## Europäisches Patentamt

(19) **European Patent Office**

**Office européen des brevets**

(11) Veröffentlichungsnummer: **0 011 724**
**B1**

(12) # EUROPÄISCHE PATENTSCHRIFT

(45) Veröffentlichungstag der Patentschrift:
30.12.81

(51) Int. Cl.³: **G 01 R 33/18**

(21) Anmeldenummer: **79104233.6**

(22) Anmeldetag: **31.10.79**

(54) Verfahren zur direkten Bestimmung der Magnetostriktionskonstanten und Vorrichtung zur Durchführung desselben.

(30) Priorität: **30.11.78 DE 2851771**

(43) Veröffentlichungstag der Anmeldung:
**11.06.80 Patentblatt 80/12**

(45) Bekanntmachung des Hinweises auf die Patenterteilung:
**30.12.81 Patentblatt 81/52**

(84) Benannte Vertragsstaaten:
**DE FR GB**

(56) Entgegenhaltungen:
DE-A-1 766 533
DE-A-2 229 224
DE-B-1 242 754
FR-A-1 491 709
FR-A2-2 386 047
US-A-3 706 026

(73) Patentinhaber: **International Business Machines Corporation, Armonk, N.Y. 10504 (US)**

(72) Erfinder: **Trippel, Gerhard, Dr., Steinenbronner Strasse 15, D-7032 Sindelfingen (DE)**
Erfinder: **Brunsch, Arwed, Dr., Am Bopserweg 8, D-7000 Stuttgart 1 (DE)**
Erfinder: **Ruh, Wolf-Dieter, Sommerhofenstrasse 152/1, D-7032 Sindelfingen (DE)**
Erfinder: **Schneider, Jochen, Burgenstrasse 39, D-7301 Gärtringen-Rohrau (DE)**

(74) Vertreter: **Herzog, Joachim, Dipl.-Ing et al, Schönaicher Strasse 220, D-7030 Böblingen (DE)**

ACTORUM AG.

# Verfahren zur direkten Bestimmung der Magnetostriktionskonstanten und Vorrichtung zur Durchführung desselben

Die Erfindung betrifft ein Verfahren zur direkten Bestimmung der Magnetostriktionskonstanten gemäss dem Oberbegriff des Anspruches 1 sowie eine Vorrichtung zur Durchführung dieses Verfahrens.

Die Kenntnis der Sättigungsmagnetostriktion bzw. der Magnetostriktionskonstanten, die ein Eigenschaftsmerkmal des magnetischen Materials ist, ist für die Diskussion des magnetischen Verhaltens dieses Materials, insbesondere dieses Materials in Form von dünnen Schichten, von besonderer Bedeutung.

Die Bestimmung der Magnetostriktionskonstanten von dünnen Filmen gestaltet sich schwierig. Beispiele für Messmethoden sind einmal enthalten in einem Artikel mit der Überschrift «Die Abhängigkeit der Sättigungsmagnetostriktion von der Legierungszusammensetzung ferromagnetischer Aufdampfschichten» von H. Hoffmann und H. Friedrich, erschienen in Z. angew. Phys., 26, Bd., Heft 2, 1969, Seiten 141 bis 145, und zum anderen in einem Artikel «The Measurement of Magnetostriction in Ferromagnetic Thin Films» von E. Klokholm, erschienen in IEEE Transaction on Magnetics, Vol. MAG-12, No. 6, Nov. 1976, Seiten 819 bis 821.

Bei dem von Hoffmann und Friedrich angegebenen Verfahren werden sehr dünne Glimmerträger von etwa 15 μm Dicke als Substrat benutzt. Auf dieses Substrat wird eine ferromagnetische Schicht in der Grössenordnung von 100 nm aufgedampft. Auf Grund der Magnetostriktionswirkung dieser dünnen Schicht verbiegt sich der Träger, wenn die Sättigungsrichtung der Magnetisierung in der Schichtebene geändert wird. Diese Verbiegungen des Trägers werden aus seinem Oberflächenprofil interferrometrisch bestimmt. Dabei lassen sich aus den Krümmungsänderungen des Trägers die Spannungsänderungen in der Schicht und daraus wiederum die Magnetostriktionskonstante berechnen. Die Schwierigkeiten dieses Verfahrens liegen einmal darin, dass eine gewisse Kraft zur messbaren Verbiegung des Glimmerträgers notwendig ist, zum anderen darin, dass die Glimmerträger nur mit Hilfe einer besonders sorgfältigen Spalttechnik präpariert werden können und nur solche Träger überhaupt verwendbar sind, die im unbedampften Zustand ein bereits auswertbares Interferenzbild mit bis zum Rand reichenden Interferenzlinien aufweisen. Die Berechnung der Magnetostriktionskonstanten selbst erfolgt dann auf Grund der Auswertung photographischer Aufnahmen, die man von diesen Bildern gemacht hat. Dies ist insgesamt gesehen ein mühsamer und umständlicher Weg, der im übrigen sehr aufwendig und zeitraubend ist.

Bei dem von E. Klokholm angegebenen Verfahren wird davon ausgegangen, dass die Anlegung eines Magnetfeldes parallel zu einem feromagnetischen Film, der auf einer Seite eines einseitig eingespannten Substrats aufgebracht ist, eine kleine Auslenkung des freien Endes bewirkt. Diese Auslenkung wird gemessen und daraus die Magnetostriktion bestimmt, da diese proportional der Auslenkung ist. Um diese Auslenkung in Abhängigkeit der angelegten Magnetfeldstärke zu messen, ist ein Glassubstratträger mit einseitiger Dünnfilmbeschichtung einseitig eingespannt. Am freien Ende ist auf der beschichteten Seite gegenüberstehend eine feste Platte angeordnet, die zusammen mit dem freien Ende der Probe die Abstimmkapazität eines Oszillators bildet. Auf Grund der Auslenkung des freien Endes ändert sich die Kapazität dieses Abstimmkondensators und somit die Frequenz des Oszillators. Diese Frequenzänderung wird bestimmt, ebenso wie das Vorzeichen der Magnetostriktion unmittelbar aus dem Anstieg oder dem Abfall der Oszillatorfrequenz bestimmt wird. Nachteilig bei dieser Methode ist es, dass zur Erzielung eines einigermassen messbaren Ausschlags des freien Endes der Probe zunächst einmal ein relativ langer Substratträger notwendig ist und dass zum anderen eine relativ grosse bzw. dicke Schicht für messbare Auslenkung notwendig ist. Darüberhinaus ergibt sich auf Grund des Messprinzips, das auf einer statischen Auslenkung des freien Endes auf die feststehende Kondensatorplatte hin oder von dieser weg basiert, die Messgrösse stark von Vibrationen der gesamten Apparatur abhängig ist und damit das Messergebnis leicht verfälschbar ist. Dieses Messprinzip erscheint daher für Routinemessungen nicht geeignet zu sein.

Aufgabe vorliegender Erfindung ist es, das bekannte direkte Verfahren so auszugestalten, dass es mit einfacheren Mitteln zu besseren Messergebnissen bei grösserer Unempfindlichkeit, insbesondere gegenüber Vibrationen, und grösserer Messempfindlichkeit führt. Weiterhin ist eine Vorrichtung anzugeben, die zur Durchführung dieses Verfahrens besonders geeignet ist.

Diese Aufgabe wird im Hinblick auf das Verfahren gemäss dem Oberbegriff des Anspruchs 1 dadurch gelöst, dass die Merkmale des kennzeichnenden Teils des Anspruchs 1 angewendet werden. Vorteilhafte Ausgestaltungen und Weiterbildungen dieses Verfahrens sind in den entsprechenden Unteransprüchen der Verfahrensansprüche niedergelegt.

Hinsichtlich der Vorrichtung zur Durchführung des erfindungsgemässen Verfahrens werden erfindungsgemäss die Merkmale angewendet, die im ersten Vorrichtungsanspruch niedergelegt sind. Vorteilhafte Ausgestaltungen und Weiterbildungen dieses Vorrichtungsanspruches sind in den entsprechenden, zugehörigen Unteransprüchen niedergelegt.

In vorteilhafter Weise lässt sich auf Grund der Erfindung die Magnetostriktionskonstante genauer, einfacher und unter weniger aufwendigen Bedingungen ermitteln. Somit ist auch die Grundlage geschaffen, um zu Routinemessungen überzugehen, die bei anderen Gelegenheiten und zu anderen Zwecken technisch interessant sind.

Das erfindungsgemässe Verfahren sowie die erfindungsgemässe Vorrichtung zur Durchführung dieses Verfahrens ist nachstehend im Zusammenhang mit dem in den Figuren dargestellten Ausführungsbeispiel näher erläutert.

Die Figuren zeigen im einzelnen:
Fig. 1 schematisch den Aufbau einer Anordnung zur Durchführung des erfindungsgemässen Verfahrens;
Fig. 2 im doppeltlogarithmischen Massstab die Magnetostriktion verschiedener Proben in Abhängigkeit von der angelegten Wechselstrom-Magnetfeldstärke und
Fig. 3 schematisch die Abhängigkeit der Schwingungsamplitude von der angelegten Frequenz des Wechselspannungs-Magnetfeldes.

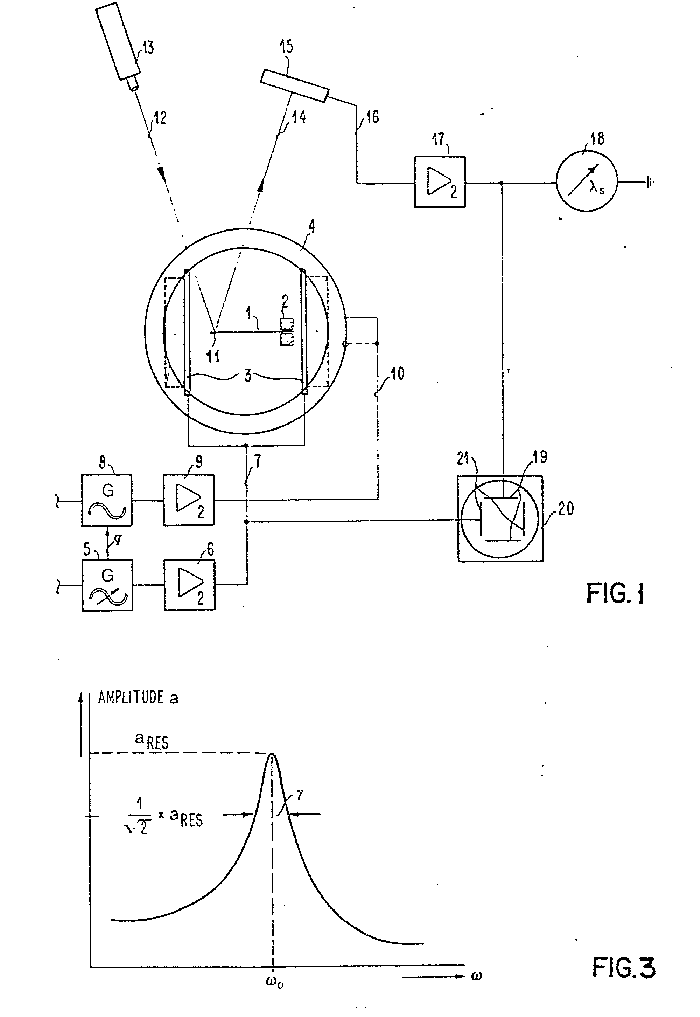

Wie in Fig. 1 dargestellt ist, ist eine Probe 1 mit einem Ende in einer Halterung 2 eingespannt. Um die Probe 1 herum ist zum einen ein erstes Helmholtz-Spulenpaar 3 angeordnet und senkrecht dazu ein zweites Paar 4 von Helmholtz-Spulen, von denen wegen der Anordnung hintereinander nur das vordere zu sehen ist. Die beiden Paare 3 und 4 sind vorzugsweise unterschiedlich gross gestaltet, so dass man sie möglichst nahe an die Probe 1 heranbringen kann. Die Anordnung ist dabei so getroffen, dass die Probe 1 im Zentrum der beiden Spulenpaare ist.

Das erste Helmholtz-Spulenpaar 3 wird von einem Generator 5 über einem Leistungsverstärker 6 und die Leitung 7 mit Wechselspannung beaufschlagt. Durch Verstellung der Frequenz des Generators 5 und durch die Verstellung der Leistungsverstärkung des Verstärkers 6 ist das von dem Helmholtz-Spulenpaar 3 erzeugte magnetische Wechselfeld in seiner Frequenz und in seiner Stärke veränderbar und einstellbar. Das zweite Paar 4 von Helmholtz-Spulen, welches ein Feld senkrecht zu dem Feld des Spulenpaares 3 erzeugen soll, wird von einem Generator 8 über einen Leistungsverstärker 9 und die Leitung 10 gespeist. Die beiden Generatoren 5 und 8 sind miteinander über eine mit φ bezeichnete Leitung verbunden, wodurch angedeutet sein soll, dass der Generator 5 die Frequenz bestimmt, der Generator 8 ebenfalls diese Frequenz abgibt, jedoch in einer um φ verschobenen Phasenlage. Vorzugsweise sind dies 90°.

Die beiden Leistungsverstärker 6 und 9 können auch die zwei Kanäle eines einzigen Leistungsverstärkers sein, so dass die Stärke des Feldes, bzw. der beiden Felder, welche von den Helmholtz-Spulenpaaren 3 und 4 erzeugt werden, in ihrer Grösse gleichsinnig, möglicherweise auch gleich im absoluten Betrag, zu verändern sind.

Durch das auf die einseitig eingespannte Probe 1 einwirkende Magnetfeld, das bei einer Phasenverschiebung um 90° zwischen den beiden Generatoren 5 und 8 ein resultierendes Rotationsfeld ist, wird die Probe 1 dann in Schwingung versetzt, wenn die auf dem Glassubstrat aufgebrachte Schicht magnetostriktiv ist. Um die Schwingung des freien Endes 11 der Probe 1 festzustellen, wird der Strahl 12 einer Strahlquelle 13, vorzugsweise ein Laserstrahl einer Laserquelle, gelenkt. Der von der Oberfläche der Probe 1 reflektierte Strahl 14 wird mittels einer positionsempfindlichen Photodiode 15 ausgewertet. Auf Grund der Lage des reflektierten Strahles 14, gibt die Photodiode 15 ein Signal auf ihrer Ausgangsleitung 16 ab, welches ein Abbild der Schwingung des freien Endes 11 der Probe 1 ist.

Dieses Signal auf Leitung 16, welches ein Wechselstromsignal ist, wird in einem Wechselstromverstärker 17 verstärkt und zum einen zur direkten sichtbaren Darstellung auf ein ablesbares Messgerät 18 gegeben sowie andererseits auf beispielsweise das vertikale Ablenkplattenpaar 19 eines Oszillographen 20, an dessen horizontalem Ablenkplattenpaar 21 die erregende Frequenz für das Wechselstrommagnetfeld auf Leitung 7 angelegt wird. Um den reflektierten Lichtstrahl 14 richtig einfangen zu können, ist vorzugsweise die positionsempfindliche Photodiode 15 in zumindest zwei zueinander senkrecht stehenden Ebenen sowie senkrecht zum reflektierten Lichtstrahl 14 verschiebbar angeordnet. Diese Verstellmöglichkeit für die positionsempfindliche Photodiode 15 ist auch deshalb wesentlich, um über einen möglichst langen Weg für den reflektierten Strahl 14 eine dementsprechend grosse Auslenkung des Strahls am Auftreffpunkt auf der Photodiode 15 zu erreichen, damit auf diese Weise die optische Verstärkungsmöglichkeit gut genutzt wird.

Die in der Einspannvorrichtung 2 eingespannte Probe 1 besteht aus einem Glasträger bzw. einem Glassubstrat, welches eine Dicke im Bereich von etwa 0,3 bis 0,4 mm aufweist und flächenmässig etwa 20×20 mm beträgt. Auf dieses Glassubstrat ist einseitig eine dünne Schicht des zu untersuchenden magnetischen Materials aufgebracht, und zwar in einer Schichtdicke von etwa einigen 100 nm. Weist das magnetische Material die Fähigkeit der Magnetostriktion auf, dann dehnt es sich oder zieht es sich zusammen, wenn ein magnetisches Feld angelegt ist. Bei einem magnetischen Wechselfeld tritt dann ein Schwingen der Probe 1 um ihren Einspannpunkt bei der Klemmvorrichtung 7 auf. Die Frequenz der Schwingung ist doppelt so gross wie die Frequenz des erregenden Magnetfeldes. Erfindungsgemäss wird die Frequenz des erregenden Feldes so eingestellt und gewählt, dass die Probe in ihrer Resonanzfrequenz schwingt. Dies ist deswegen so gewählt, weil durch die Resonanzfrequenz die mechanischen Eigenschaften wie die Elastizitätskonstante des Substrats $E_s$ und die Dicke des Substrats h vollständig beschrieben sind.

Unter gewissen Voraussetzungen und bei einer Reihe von bestimmten Materialien gilt folgender Zusammenhang zwischen der durch die Magnetostriktion verursachten Längenänderungen $\triangle 1/1$ und der Magnetostriktionskonstanten $\lambda_s$:

$$\triangle 1/1 = -(3/2)\,\lambda_s\,\,(M/M_s)^2 \qquad\qquad (A)$$

wobei M die Magnetisierung entsprechend dem

anliegenden Feld und $M_s$ die Sättigungsmagnetisierung bedeuten.

Die Einwirkung eines magnetischen Wechselfeldes auf die einseitig eingespannte Probe 1 verursacht auf Grund der Mangetostriktion eine Schwingung, die bei kleinen Amplituden linear gemäss folgender Gleichung behandelt werden kann:

$$\frac{d^2y}{dt^2} + \gamma \, \frac{dy}{dt} + \omega_o{}^2 y = f(t) \qquad (B)$$

wobei $\omega_o$ die Resonanzfrequenz und $\gamma$ die Dämpfung des Systems bedeuten, f(t) ist die Antriebskraft der Schwingung, welche durch die Magnetostriktionseffekte hervorgerufen wird. Unter der Annahme einer linearen Magnetisierungskurve, die im übrigen auf drei Wegen erhalten werden kann, nämlich erstens Anlegung eines Wechselfeldes in Richtung der harten Achse eines isotropen Films, zweitens Anlegung eines Gleichfeldes senkrecht zu einem Wechselfeld und drittens rotierende Magnetisierung durch ein Rotationsfeld, ergibt sich als Lösung für die Gleichung (B), wenn die Frequenz des erregenden Feldes wesentlich kleiner als die Resonanzfrequenz ist, für die Schwingung des freien Endes der einseitig eingespannten Probe bei der Länge l:

$$y = -\frac{1}{2} Kl^2 \sin^2 \omega_H t \qquad (C)$$

wobei

$$K = 9\lambda_s \frac{d}{h^2} \frac{E_F}{E_s} \left(\frac{M}{M_s}\right)^2 \qquad (D)$$

dabei
bedeuten in der Angabe für die Konstante K
d die Dicke des zu untersuchenden Films aus magnetischem Material,
h die Substratdicke,
$E_F$ und $E_s$ die Elastizitätskonstanten des Films bzw. des Substrats.

Die Lösung der Gleichung (B) ist eine Schwingung mit der Frequenz $\omega = 2\omega_H$ und der resultierenden, maximalen Amplitude im Falle geringer Dämpfung, wenn $\omega = \omega_o$ ist, das Ganze also in Resonanz schwingt. Die resultierende Amplitude beträgt dann:

$$a_{res} = \frac{\omega_o Kl^2}{4\gamma} \qquad (E)$$

Löst man die beiden Gleichungen D und E nach der Magnetostriktionskonstanten $\lambda_s$ auf, so ergibt sich:

$$\lambda_s = \frac{4E_s h^2 \gamma}{9E_F l^2 d\omega_0} \left(\frac{M}{M_s}\right)^2 \cdot a_{res} \qquad (F)$$

Das Dämpfungsmass $\gamma$ ist bestimmt durch die Beziehung:

$$\gamma = 2(\overline{\omega} - \omega_0),$$

wobei $\overline{\omega}$ bei der Amplitude $a_{(\overline{\omega})} = \sqrt{\dfrac{1}{2}} \cdot a_{res}$ gegeben ist.

Die elastische Konstante des Substrates $E_s$ kann aus der Theorie der schwingenden Platte bei geeigneten Grenzbedingungen für die erste harmonische Schwingung entnommen werden, und zwar bei einem eingespannten Ende und einem freien Ende gemäss der Gleichung:

$$\omega_o = (\kappa l)^2 \, \frac{h}{l^2} \sqrt{\frac{E_s}{12\rho}} \qquad (G)$$

wobei $(\kappa l) = \dfrac{\pi}{2+0,3043} = 1,8751$

der Reflektionsfaktor im Falle einer eingespannten und einer freien Seite und wobei $\rho$ die Dichte des Substrats angibt.

Wird die Gleichung G nach $E_s$ aufgelöst und in die Gleichung F eingesetzt, dann ergibt sich schliesslich für die Magnetostriktionskonstante:

$$\lambda_s = 0,4314 \, \frac{\gamma \omega_o l^2 \rho}{E_F d} \cdot a_{res} \qquad (H),$$

für den Wert der Elastizitätskonstante des Films $E_F$ wird der aus Messungen für Kompaktmaterialien bekannte Wert eingesetzt. In weiterer Vereinfachung ergibt sich dann folgende Gleichung für die Magnetostriktionskonstante:

$$\lambda_s = K_1 \cdot \gamma \cdot \omega_o \cdot a_{res} \qquad (I)$$

mit $\quad K_1 = 0,4314 \, \dfrac{l^2 \rho}{E_F d} \cdot$

Wie diese Gleichung zeigt, ist die Magnetostriktionskonstante $\lambda_s$ proportional zur Resonanzamplitude $a_{res}$. Die anderen Faktoren sind im wesentlichen von den Eigenschaften und den Abmessungen des Substrats bestimmt und als Konstante zu betrachten. Bei Einstellung der Resonanzfrequenz $\omega_o$ und Ermittlung des Dämpfungsfaktors $\gamma$, welche im übrigen bei der Verwendung von immer den gleichen Substraten, jedoch beschichtet mit unterschiedlichen magnetischen Materialien als konstant betrachtet werden können, kann davon ausgegangen werden, dass durch die Ablesung der Resonanzamplitude auf der Photodiode 15 bzw. durch direkte Anzeige auf dem Gerät 18 in einfachster Weise die Magnetostriktionskonstante unterschiedlicher Materialien, jedoch bei den vorausgesetzten gleichen Substraten, einfach ermittelt wird und somit direkt ablesbar ist.

Gemäss der Gleichung A ist die Längenänderung $\triangle l/l$ auf Grund des Magnetostriktionseffektes proportional zu $(M/M_s)^2$.

Unter der Voraussetzung einer linearen Magnetisierungskurve ist eine quadratische Abhän-

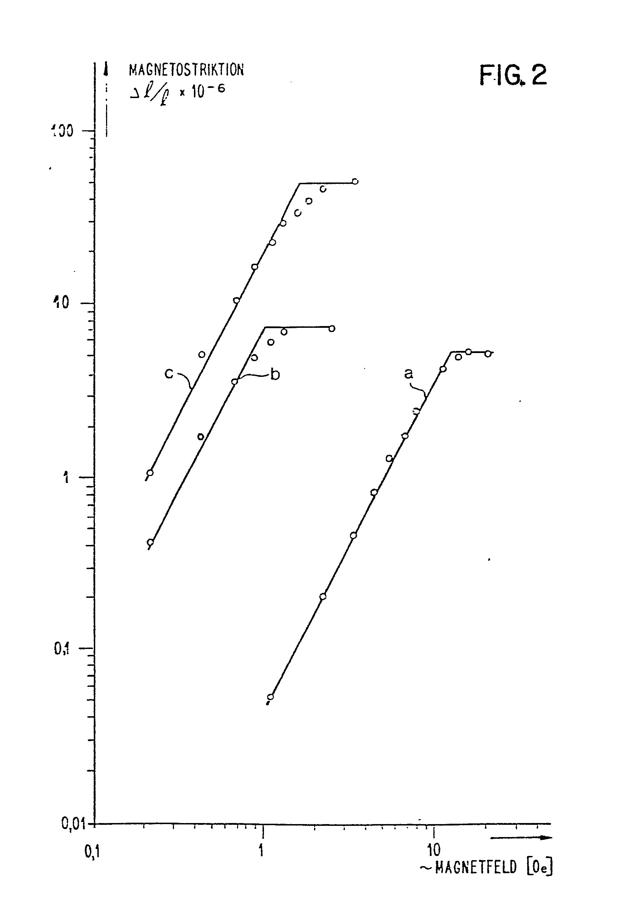

gigkeit der Magnetostriktion $\triangle l/l$ vom angelegten magnetischen Wechselfeld zu erwarten. In Fig. 2 ist in doppeltlogarithmischem Massstab die Magnetostriktion gemäss der Gleichung A in Abhängigkeit von der angelegten Feldstärke des Wechselfeldes dargestellt. Beide Massstäbe sind logarithmisch. Zur Ermittlung der als kleine Kreise eingezeichneten Messpunkte ist die Gleichung H im Zusammenhang mit der Gleichung A verwendet worden. Die drei dargestellten Kurven folgen dem quadratischen Gesetz, ausgenommen jedoch die Bereiche in der Nähe der Sättigung. Die Abweichungen von der quadratischen Abhängigkeit sind in diesem Sättigungsbereich ausgeprägter, je nachdem wie linear die Magnetisierungskurven der einzelnen Probematerialien sind. Die Abweichung der Kurve a, die für amorphes $Co_{74}Fe_6B_{20}$ gilt, ist klein und dieses Material weist auch eine sehr lineare Magnetisierungskurve auf. Die Magnetisierungskurve der Beispiele b und c, dies sind amorphes $Fe_{80}B_{20}$ bzw. kristallines $Ni_{80}Fe_{20}$ sind stärker und die Magnetisierungskurven dieser Proben sind nicht so linear wie bei der Probe des Materials gemäss der Kurve a. Die Magnetostriktionskonstante dieser Proben ergeben sich aus folgender Tabelle:

| Probe | Material | $\lambda_s$ |
|---|---|---|
| a | $Co_{74}Fe_6B_{20}$ (amorph) | $3,67 \times 10^{-6}$ |
| b | $Fe_{80}B_{20}$ (amorph) | $33 \times 10^{-6}$ |
| c | $Ni_{80}Fe_{20}$ (kristallin) | $5 \times 10^{-6}$ |

In Fig. 3 ist schematisch die Amplitude in Abhängigkeit von der Frequenz dargestellt, mit der das erregende Magnetfeld die Probe 1 in Fig. 1 zum Schwingen bringt. Gemessen wird dabei die Amplitude des freien Endes 11 der Probe. Durch Beobachtung der Kurve auf dem Oszilloskopen 20 können die für die Gleichung I interessanten Werte, nämlich $\gamma$, $\omega_o$ und $a_{res}$ ermittelt werden. Mit Hilfe des Generators 5 wird die Resonanzfrequenz $\omega_o$ eingestellt und die Resonanzstelle herausgefunden, mit Hilfe der Verstärker 6 und 9 wird das Magnetfeld auf eine Stärke gebracht, welches für die Sättigung der Probe notwendig ist, um dabei bei der Resonanzfrequenz die maximale Resonanzamplitude zu erreichen, die als $a_{res}$ in Fig. 3 eingezeichnet ist. Liegen beide Werte fest, schwingt also die Probe 1 mit ihrer maximalen Amplitude bei Resonanz, so lässt sich die Dämpfung $\gamma$, wie eingezeichnet in Fig. 3, leicht aus der Beobachtung dieser Kurve entnehmen. Die Grössenordnung der Resonanzfrequenz $\omega_o$ liegt bei etwa 700 bis 1200 Hz, wenn Glassubstrate im Dickenbereich von etwa 0,3 bis 0,4 mm verwendet werden, die flächenmässigen Abmasse des Glassubstrates $20 \times 20$ mm² sind und die effektive Länge l, die zum Schwingen gebracht wird, etwa 17 mm beträgt.

Eine Aussage über das Vorzeichen der Magnetostriktionskonstanten lässt sich durch den Vergleich der Phase der schwingenden Probe 1 und des erregenden magnetischen Wechselfeldes machen.

Auf Grund des erfindungsgemässen Verfahrens und der dazu angegebenen Vorrichtung zur Durchführung lassen sich mit grosser Genauigkeit Magnetostriktionskonstanten bestimmen, die um den Faktor 100 kleiner sind als mit der Methode nach Klokholm. Darüberhinaus ist die erfindungsgemässe Vorrichtung gegenüber Vibrationen auf Grund des Resonanzverfahrens im wesentlichen unempfindlich. Die Möglichkeit der Wechselstromverstärkung bringt erhebliche weitere Vorteile. Aus all diesen Vorteilen ergibt sich schliesslich die Möglichkeit, mit Hilfe des erfindungsgemässen Verfahrens und seiner Vorrichtung zu einer Routinemessung der Magnetostriktion bzw. der Magnetostriktionskonstanten überzugehen. Mit Hilfe dieser routinemässigen Messung ist die wesentliche Möglichkeit eröffnet, die Materialzusammensetzung, beispielsweise beim Permalloy derart zu beobachten und zu steuern, dass die Bestimmung der Mangetostriktionskonstanten im quasi Null-Bereich dazu benutzt wird, steuernd auf die Zusammensetzung der Legierung einzuwirken, um ein Permalloy mit praktisch nicht vorhandener Magnetostriktion zu erzeugen. Derartige Möglichkeiten spielen bei der Herstellung von Dünnfilmköpfen und anderen dünnen Magnetmaterialien eine sehr wesentliche Rolle.

## Patentansprüche

1. Verfahren zur direkten Bestimmung der Magnetostriktionskonstanten von weichmagnetischen und magnetisch isotropen Dünnschichtmaterialien, wobei dieses Material auf einem Substrat aufgebracht ist und die so gestaltete Probe einseitig eingespannt bei Einwirkung eines Magnetfeldes durch Ausnutzung des dabei wirksamen Magnetostriktionseffektes ausgelenkt wird und über die Auslenkung, die ein Mass für die Magnetostriktionskonstante ($\lambda_s$) darstellt, diese bestimmt wird,
dadurch gekennzeichnet, dass
a) die Probe (1) einem magnetischen Wechselfeld ausgesetzt wird,
b) das magnetische Wechselfeld frequenzmässig so eingestellt wird, dass die Probe (1) in Resonanzschwingung versetzt wird und
c) die Schwingungsamplitude ($a_{res}$) der Probe (1) auf optisch-elektrischem Wege ermittelt wird.

2. Verfahren nach Anspruch 1,
dadurch gekennzeichnet,
dass das magnetische Wechselfeld in seiner Stärke so eingestellt wird, dass die magnetische Dünnschicht der Probe (1) in die Sättigung kommt.

3. Verfahren nach Anspruch 1 oder 2,
dadurch gekennzeichnet,
dass das magnetische Wechselfeld ein rotierendes Feld ist.

4. Verfahren nach einem der Ansprüche 1 bis 3,
dadurch gekennzeichnet,
dass über einen von der Probe (1) reflektierten Licht-, vorzugsweise Laserstrahl (12, 14), eine positionsempfindliche Photodiode (15) belichtet wird, die ein der Schwingungsamplitude ($a_{res}$) entsprechendes Ausgangssignal (16) abgibt.

5. Vorrichtung zur Durchführung des Verfahrens nach einem der vorigen Ansprüche, wobei eine Spannvorrichtung (2) für die einseitige Einspannung der Probe (1) sowie Helmholtz-Spulen (3, 4) zur Magnetfelderzeugung vorgesehen sind, dadurch gekennzeichnet,
dass ein frequenzmässig einstellbarer Oszillator (5) vorgesehen ist, dessen Ausgang einerseits einem Paar (3) von Helmholtz-Spulen und andererseits einem zweiten Oszillator (8) zugeführt ist, wobei der zweite Oszillator (8) ausgangsseitig (10) mit dem zweiten Paar (4) von Helmholtz-Spulen verbunden ist und dieselbe Frequenz, jedoch mit einstellbarer Phasenlage ($\varphi$), wie der erste Oszillator (5), abgibt,
dass eine Strahlquelle (13) vorgesehen ist, deren Lichtstrahl (12) auf das freie Ende (11) der Probe (1) gerichtet ist,
dass eine positionsempfindliche Photodiode (15) vorgesehen ist, auf die der von der Probe (1) reflektierte Strahl (14) auftrifft,
und dass das Ausgangssignal (16) der Photodiode (15) einem die Magnetostriktionskonstante ($\lambda_s$) anzeigenden Messgerät (18) zugeführt ist.

6. Vorrichtung nach Anspruch 5,
dadurch gekennzeichnet,
dass die positionsempfindliche Photodiode (15) in zwei zueinander und zur Richtung des einfallenden Strahls (14) senkrechten Richtungen verschiebbar angeordnet ist.

7. Vorrichtung nach Anspruch 5 oder 6,
dadurch gekennzeichnet,
dass die verwendeten Paare (3, 4) von Helmholtz-Spulen unterschiedliche Durchmesser aufweisen, um ein enges Heranrücken an die Probe (1) zu ermöglichen.

8. Vorrichtung nach einem der Ansprüche 5 bis 7,
dadurch gekennzeichnet,
dass unmittelbar an die Ausgangsseite der beiden Oszillatoren (5, 8) sowie der Photodiode (15) jeweils Wechselstromverstärker (6, 9, 17) angeschlossen sind.

9. Vorrichtung nach einem der Ansprüche 5 bis 8,
dadurch gekennzeichnet,
dass ein Oszilloskop (20) vorgesehen ist, an dessen eines Ablenkplattenpaar (21) der Ausgang des frequenzbestimmenden ersten Oszillators (5) und an dessen zweites Ablenkplattenpaar (19) der Ausgang der Photodiode (15) angeschlossen ist.

**Claims**

1. Method of directly determining the magnetostriction constant of soft magnetic and isotropic magnetic thin film materials, wherein the material is applied to a substrate and the sample (1) so formed and clamped at one end is deflected under the influence of a magnetic field through use of the magnetostriction effect, the magnetostriction constant being determined from the deflection which represents a measure of the magnetostriction constant ($\lambda_s$), characterized in that
a) the sample (1) is exposed to a magnetic AC field,
b) the magnetic AC field is adjusted with respect to frequency in such a manner that the sample (1) can be set to vibrate in resonance, and
c) the vibration amplitude ($a_{res}$) of the sample (1) is determined opto-electrically.

2. Method as claimed in claim 1, characterized in that the magnetic AC field is adjustable in its strength to cause the magnetic thin film of the sample (1) reach saturation.

3. Method as claimed in claim 1 or 2, characterized in that the magnetic AC field is a rotating field.

4. Method as claimed in one of claims 1 to 3, characterized in that via a light beam, preferably a laser beam (12, 14) reflected from the sample (1), a position-sensitive photodiode (15) is exposed that emits an output signal (16) that corresponds to the vibration amplitude ($a_{res}$).

5. Device for carrying out the method as claimed in one of the preceding claims, comprising a clamping device (2) for the one-end clamping of the sample (1) and Helmholtz coils for the generation of a magnetic field being provided, characterized in that a frequency adjustable oscillator (5) is provided whose output on the one hand is applied to a pair (3) of Helmholtz coils, and on the other to a second oscillator (8), the second oscillator (8) being connected at its output side (10) to the second pair (4) of Helmholtz coils, and emitting the same frequency as the first oscillator (5) but with adjustable position of phase ($\varphi$), that a radiation source (13) is provided whose light beam (12) is directed onto the free end (11) of the sample (1), that a position-sensitive photodiode (15) is provided onto which impinges the beam (14) reflected from the sample (1), and that the output signal (16) of the photodiode (15) is applied to a measuring device (18), indicating the magnetostriction constant ($\lambda_s$).

6. Device as claimed in claim 5, characterized in that the position-sensitive photodiode (15) is arranged in such a manner that it can be shifted into two directions that are perpendicular to each other and to the direction of the incident beam (14).

7. Device as claimed in claim 5 or 6, characterized in that the pairs (3, 4) of Helmholtz coils used have different diameters for permitting a close approach to the sample (1).

8. Device as claimed in one of claims 5 to 7, characterized in that directly connected to the output side of the two oscillators (5, 8) and of the photodiode (15) AC amplifiers (6, 9, 17) are provided.

9. Device as claimed in one of claims 5 to 8, characterized in that an oscilloscope (20) is provided at whose one pair of deflector plates (21) the output of the frequency-determining first oscillator (5), and at whose second pair deflector plates (19) the output of the photodiode (15) is connected.

## Revendications

1. Procédé pour déterminer directement les constantes de magnétostriction de matériaux à film mince, magnétique, isotrope et à aimantation douce, dans lequel ce matériau est déposé sur un substrat et l'échantillon (1) ainsi obtenu est serré à une extrémité pour être dévié sous l'effet d'un champ magnétique en utilisant l'effet de magnétostriction et dans lequel la constante de magnétostriction ($\lambda_s$) est déterminée au moyen de la déviation, procédé caractérisé en ce que
a) l'échantillon (1) est soumis à un champ magnétique alternatif,
b) la fréquence du champ magnétique alternatif est réglée, de telle sorte que l'échantillon (1) oscille en résonance, et
c) l'amplitude de l'oscillation ($a_{res}$) de l'échantillon (1) est déterminée par un moyen opto-électrique.

2. Procédé selon la revendication 1, caractérisé en ce que la valeur du champ magnétique alternatif est choisie de telle sorte que la couche mince magnétique de l'échantillon (1) arrive à saturation.

3. Procédé selon la revendication 1 ou 2, caractérisé en ce que le champ magnétique alternatif est un champ tournant.

4. Procédé selon l'une des revendications 1 à 3, caractérisé en ce que l'on expose une photodiode (15) sensible à la position à l'aide d'un faisceau de lumière, de préférence un faisceau laser (12, 14), réfléchi par l'échantillon (1), ladite photodiode émettant un signal de sortie (16) correspondant à l'amplitude de l'oscillation ($a_{res}$).

5. Dispositif pour mettre en œuvre le procédé selon l'une quelconque des revendications précédentes, comportant un dispositif de serrage (2), pour serrer l'un des côtés de l'échantillon (1), ainsi que des bobines de Helmholtz (3, 4) pour produire un champ magnétique, dispositif caractérisé en ce qu'il comporte un oscillateur (5) à fréquence réglable dont la sortie peut, d'une part, être appliquée à une paire (3) de bobines de Helmholtz et d'autre part à un second oscillateur (8), dont la sortie (10) est connectée avec la seconde paire (4) de bobines de Helmholtz, ledit second oscillateur ayant la même fréquence, que le premier oscillateur (5) et une phase ($\varphi$) réglable, en ce qu'il comporte une source de radiation (13) dont le faisceau lumineux (12) est dirigé sur l'extrémité libre (11) de l'échantillon (1), en ce qu'il comporte une photodiode (15) sensible à la position qui est frappée par le faisceau (14) réfléchi par l'échantillon (1), et en ce que le signal de sortie (16) de la photodiode (15) est appliqué à un appareil de mesure (18), indiquant la constante de magnétostriction ($\lambda_s$).

6. Dispositif selon la revendication 5, caractérisé en ce que la photodiode (15) sensible à la position est disposée de telle sorte qu'elle peut être décalée dans deux directions verticales l'une par rapport à l'autre et par rapport à la direction du faisceau incident (14).

7. Dispositif selon la revendication 5 ou 6, caractérisé en ce que les paires (3, 4) de bobines de Helmholtz utilisées ont des diamètres différents permettant de les rapprocher de très près de l'échantillon (1).

8. Dispositif selon l'une des revendications 5 à 7, caractérisé en ce que des amplificateurs de courant alternatif (6, 9, 17) sont directement connectés à la sortie des deux oscillateurs (5, 8) et de la photodiode (15).

9. Dispositif selon l'une des revendications 5 à 8, caractérisé en ce qu'il comporte un oscilloscope (20) dont l'une des paires de plaques de déflexion (21) est connectée avec la sortie du premier oscillateur (5) déterminant la fréquence et dont l'autre paire de plaques de déflexion (19) est connectée avec la sortie de la photodiode (15).

FIG.1

FIG.3

FIG. 2